(19) Europäisches Patentamt
European Patent Office
Office européen des brevets

(11) EP 3 829 043 A1

(12) EUROPEAN PATENT APPLICATION

(43) Date of publication:
02.06.2021 Bulletin 2021/22

(51) Int Cl.:
H02M 1/42 (2007.01)     H05B 45/3725 (2020.01)
H02M 3/335 (2006.01)     G01R 21/06 (2006.01)

(21) Application number: 20206854.0

(22) Date of filing: 11.11.2020

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(30) Priority: 26.11.2019   IT 201900022158

(71) Applicants:
• OSRAM GmbH
80807 München (DE)
Designated Contracting States:
AL AT BE BG CH CY CZ DE DK EE ES FI FR GB
GR HR HU IE IS LI LT LU LV MC MK MT NL NO PL
PT RO RS SE SI SK SM TR

• OSRAM S.P.A. - SOCIETA' RIUNITE OSRAM
EDISON
CLERICI
20126 Milano (MI) (IT)

(72) Inventor: LUCCATO, Daniele
I-31052 Varago di Maserada (Treviso) (IT)

(74) Representative: Bosotti, Luciano
Buzzi, Notaro & Antonielli d'Oulx S.p.A.
Corso Vittorio Emanuele II, 6
10123 Torino (IT)

(54) ELECTRONIC CONVERTER, CORRESPONDING LIGHTING SYSTEM AND METHOD OF OPERATING AN ELECTRONIC CONVERTER

(57) An electronic converter (10) comprises two input terminals (102a, 102b) for receiving an input voltage ($V_{in,AC}$; $V_{in,DC}$) and a switching stage (110) for supplying a regulated voltage ($V_{out}$) or a regulated current ($i_{out}$) to two output terminals (104a, 104b). A voltage sensing circuit (VS) supplies a signal ($V_{sense}$) proportional to the input voltage. A current sensing circuit (CS) supplies a signal ($I_{sense}$) indicative of an input current ($I_s$). A control circuit (120) samples the signal proportional to the input voltage and the signal indicative of an input current. The current sensing circuit (CS) comprises a shunt resistance ($R_{shunt}$) connected between a first node ($N_A$) and a second node ($N_C$), a switch (S4) in parallel to the shunt resistance, and a voltage divider between the first node ($N_A$) and a supply ($V_{supply}$) node (900). The control circuit (120) measures a voltage between an intermediate node ($N_B$) of the divider and the second node ($N_C$) of the current-sensing circuit (CS) for receiving the signal ($I_{sense}$) indicative of an input current ($T_s$). The control circuit (120) opens the switch in a first time interval and closes the switch in a second time interval, and determines a value of input power as a function of values of the signal proportional to the input voltage and of the signal indicative of an input current ($T_s$) that are sampled during the first time interval.

FIG. 9

**Description**

Field of the invention

The present disclosure relates to electronic converters.

Prior art

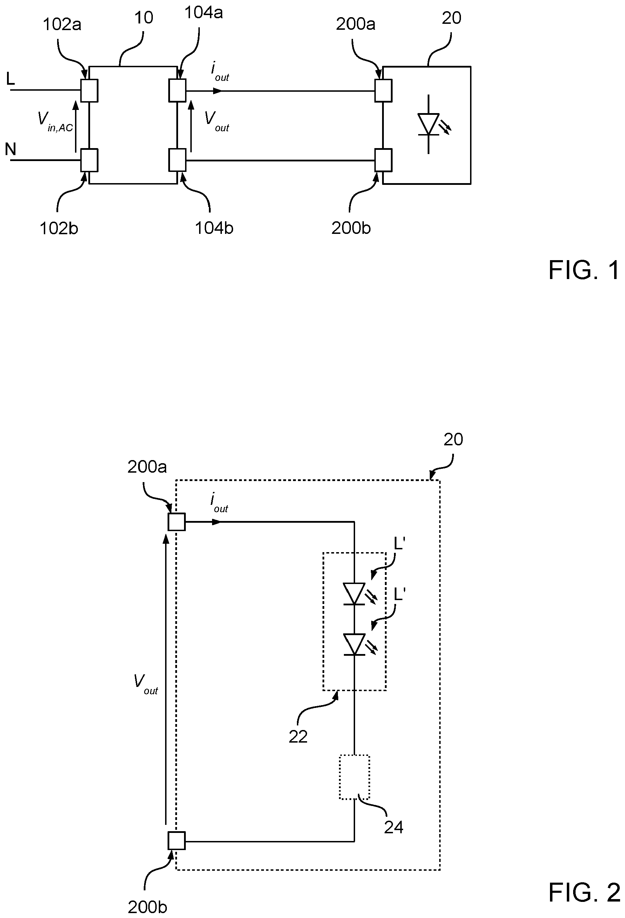

Figure 1 shows a typical lighting system comprising an electronic converter 10 and at least one lighting module 20. In general, a lighting module 20 comprises one or more light sources, which include, for example, at least one LED (Light-Emitting Diode) or other solid-state lighting means, such as laser diodes.

In particular, in the example considered, the electronic converter 10 is an AC/DC electronic converter. Consequently, the electronic converter 10 comprises two input terminals 102a and 102b (which together constitute an input port of the electronic converter) for connection to an electrical supply line having two conductors typically referred to as live L and neutral N, and two output terminals 104a and 104b (which together constitute an output port of the electronic converter) for connection to the lighting module or modules 20. Typically, the terminal 102a is connected to the live L and the terminal 102b is connected to the neutral N of the electrical supply line.

In general, the electronic converter 10 may be a voltage generator or a current generator. The lighting module 20 may be configured to be supplied by means of a regulated voltage or a regulated current.

Consequently, the electronic converter 10 receives at input, through the terminals 102a and 102b, an AC voltage $V_{in,AC}$, such as 110 or 230 VAC, and supplies at output, through the terminals 104a and 104b, a regulated voltage $V_{out}$, such as 12 or 24 VDC, or a regulated current $i_{out}$.

Figure 2 shows an example of a lighting module 20. In particular, the lighting module 20 comprises a positive input terminal 200a and a negative input terminal 200b for connection to the terminals 104a and 104b of the electronic converter 10. For instance, the lighting module 20 may be connected directly or through a cable to the electronic converter 10. Consequently, the terminal 200a is connected to the positive terminal 104a and the terminal 200b is connected to the negative terminal 104b, and the lighting module 20 receives at input the regulated voltage $V_{out}$ or the regulated current $i_{out}$.

In the example considered, the lighting module 20 is a LED module comprising one or more LEDs (or laser diodes) L' connected between the terminals 200a and 200b. For instance, the module 20 may comprise a LED chain or string 22, in which a plurality of LEDs L' (or likewise laser diodes) are connected in series.

In the case where the lighting module 20 is supplied with a regulated voltage, the lighting module 20 typically comprises a current regulator 24 connected in series to the LED string 22. In the simplest case, the current regulator 24 may be a resistor or a linear current regulator. The current regulator 24 may be implemented also with current mirrors or with a switching current regulator (also known as switched-mode current source), typically comprising an inductor and an electronic switch.

In general, also a plurality of lighting modules 20 may be connected to the electronic converter 10. For instance, in the case where a regulated voltage $V_{out}$ is used, the lighting modules 20 may be connected in parallel to the terminals 104a and 104b. Instead, in the case where a regulated current $i_{out}$ is used, the lighting modules 20 may be connected in series between the terminals 104a and 104b.

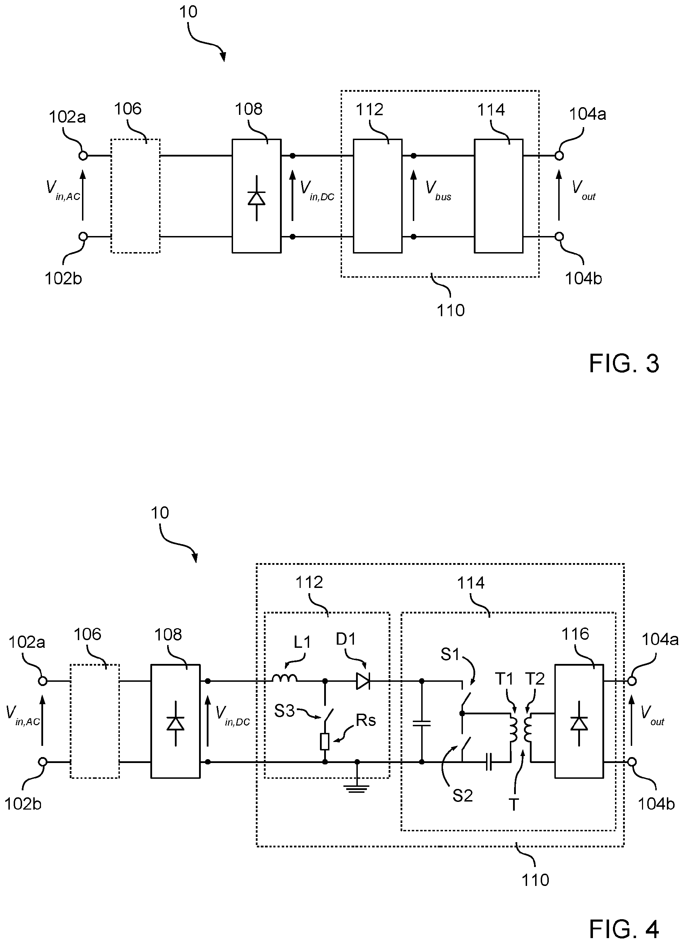

As illustrated in Figure 3, the electronic converter 10 comprises a rectifier circuit 108 and a (power) switching stage 110 between the input port 102a, 102b and the output port 104a, 104b.

In particular, the input of the rectifier circuit 108, such as a diode bridge, is connected (for example, directly) to the terminals 102a and 102b. Consequently, the rectifier circuit 108 receives at input the input voltage $V_{in,AC}$ and supplies at output a rectified voltage $V_{in,DC}$.

In general, between the input port 102a, 102b and the rectifier circuit 108 there may be provided also a filter circuit 106 configured to filter the noise produced by the electronic converter 10.

In general, the switching stage 110 comprises a DC/DC conversion circuit 114, which supplies the regulated output voltage $V_{out}$ to the output port 104a, 104b of the electronic converter 10. Between the rectifier circuit 108 and the DC/DC conversion circuit 114 there may be provided a filter circuit 112, such as a capacitor connected in parallel to the output terminals of the rectifier circuit 108. Consequently, in this case, the filter circuit 112 receives (for example, directly) the rectified voltage $V_{in,DC}$ and supplies at output a filtered voltage, typically referred to as "bus voltage" $V_{bus}$. In this case, the DC/DC conversion circuit 114 hence receives at input the bus voltage $V_{bus}$.

In addition or as an alternative to the filter circuit 112, a power factor correction (PFC) circuit may be used.

For safety reasons, the electronic converter 10 is frequently required to be an insulated converter. Consequently, in this case, as shown in Figure 4, the DC/DC conversion circuit 114 may comprise at least one transformer T, which includes a primary winding T1 and a secondary winding T2.

The DC/DC conversion circuit 114 comprises one or more electronic switches (for example, S1 and S2) configured to connect the terminals of the primary winding T1 of the transformer T selectively to the rectified voltage $V_{in,DC}$ supplied by the rectifier circuit 108 (or to the bus voltage $V_{bus}$ supplied by the filter and/or PFC circuit 112). The electronic switches S1, S2 may be implemented as transistors, for example MOS field-effect transistors (MOSFETs).

The discontinuous (pulsed, AC) voltage at the secondary side T2 of the transformer T is then converted into a DC voltage by means of a further rectifier circuit 116, typically comprising one or more diodes (for example, a diode bridge). Consequently, the input of the rectifier circuit 116 is connected (for example, directly) to the terminals of the secondary winding T2 of the transformer T and supplies at output a DC voltage/current, which in the simplest case corresponds to the output voltage/current $V_{out}/i_{out}$.

In a switching converter, the transformer T thus receives at the primary side T1 a discontinuous (pulsed, AC) voltage, which has a switching frequency determined by driving the electronic switches S1 and/or S2. The electronic converter 10 may hence comprise also a control circuit (not visible in Figure 4) configured to generate one or more driving signals for driving the DC/DC conversion circuit 114 and/or the filter circuit 112, in such a way as to regulate the output voltage $V_{out}$ or the current output $i_{out}$ on a desired value. For instance, the control circuit may generate respective driving signals for the electronic switches S1 and/or S2.

In general, the control circuit may be any analog circuit and/or a digital circuit, such as a microprocessor programmed via software code.

Figure 4 moreover illustrates an example in which the electronic converter 10 comprises a power factor correction (PFC) circuit 112, in particular a boost topology comprising an inductor L1, a diode D1, an electronic switch S3, and a resistance Rs (optional) arranged in a configuration known per se.

In the field of electronic converters, and in particular electronic converters for the supply of lighting modules (for example, LEDs), energy saving is a desired feature. Energy saving may be obtained, for example, by increasing the efficiency of the switching stage 110, or by detecting the consumption and regulating the power according to the needs.

In order to detect consumption, the control circuit may be configured to determine some data, such as the input power of the converter. In addition, the control circuit may be configured to transmit, at output from the electronic converter 10, a signal indicative of the power absorbed at input by the electronic converter.

Different methods for determining the value of the input power in an electronic switching converter are known in the art.

For example, the input power may be determined indirectly via detection of some electrical quantities in the switching stage 110 even though this method is usually not accurate.

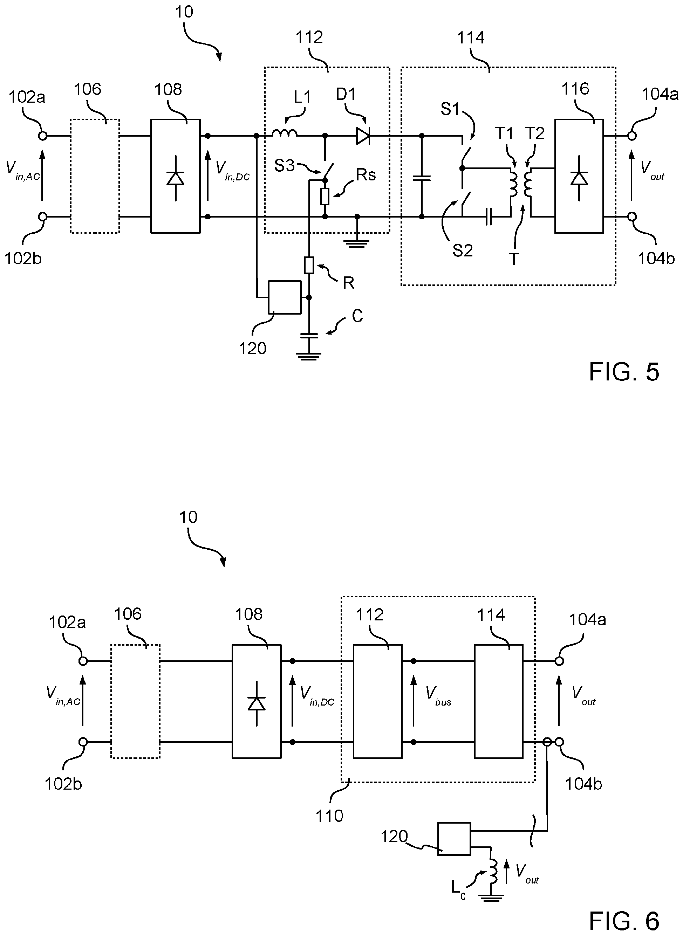

For instance, as illustrated in Figure 5, the control circuit 120 (for example, a microprocessor or microcontroller) of the electronic converter 10 may be coupled downstream of the rectifier circuit 108 for detecting the rectified voltage $V_{in,DC}$, and may be coupled (for example, via a filtering network comprising a resistance R and a capacitance C) to the resistor Rs in the PFC circuit 112 for detecting the current that flows therethrough. Measurement of the input power as a function of the rectified voltage $V_{in,DC}$ and of the current that flows in the resistor Rs may prove reasonable if the load remains constant and the input voltage does not change over time.

Alternatively, as illustrated in Figure 6, the control circuit 120 of the electronic converter 10 may be coupled downstream of the DC/DC conversion circuit 114 for detecting the output current $i_{out}$ supplied to the load, and may be configured to detect the output voltage $V_{out}$ at a secondary winding $L_0$ of the transformer T. In this way, the input power may be calculated as a function of the value of the power supplied at output by the DC/DC conversion circuit 114. This method is rather common in so far as the output current is usually well known and the output voltage can be measured easily via a secondary winding of the transformer T, or also transferred directly from the secondary side if there is electrical communication between the primary side and the secondary side.

The input power of the electronic converter 10 may hence be determined as a function of the output power and of the efficiency of the electronic converter 10. On the other hand, the efficiency of the electronic converter may vary as a function of the variations of the input voltage $V_{in,AC}$ and of the temperature, in such a way that the value determined of the input power may not be accurate even if the output power is measured in an accurate way.

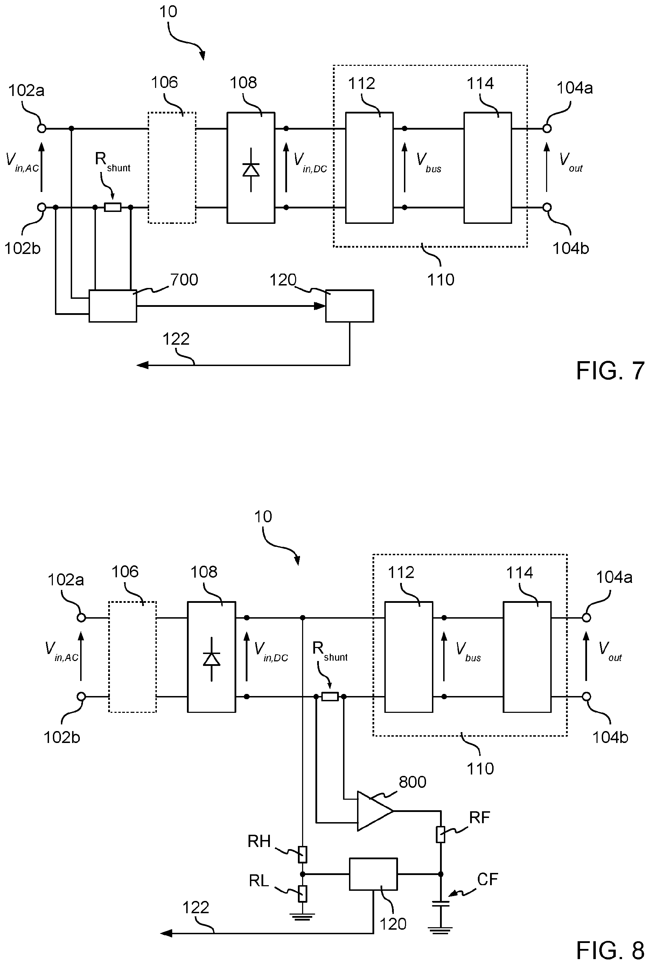

Yet a further known circuit for determining the input power of the electronic converter 10 is illustrated in Figure 7. In this circuit, a dedicated microprocessor 700 is configured to detect (directly) the voltage $V_{in,AC}$ supplied from the supply line to the terminals 102a, 102b (possibly upstream of the optional filter circuit 106) and to detect (directly) the input current, for example via a shunt resistor $R_{shunt}$ connected in series to one of the terminals 102a or 102b. The dedicated microprocessor 700 may be coupled to the control circuit 120 inside the electronic converter 10 for transmitting thereto a signal (for example, a digital signal) indicative of the input power calculated as a function of the input voltage and of the input current. The control circuit 120, which controls operation of the electronic converter 10, can gather other data and send this information at output via a communication line 122, for example a DALI communication line.

Even though the solution illustrated in Figure 7 for determining the input power may be more precise than the previous solutions, it is also typically the most expensive in terms of space occupied by the sensing circuit and of cost of the circuit itself.

Yet a further known circuit for determining the input power of an electronic converter is illustrated in Figure 8.

In this circuit, the control circuit 120 of the electronic converter 10 is configured to detect the rectified voltage $V_{in,DC}$ downstream of the rectifier circuit 108 (for example, via a resistive divider comprising the resistances RH, RL). Moreover, the electronic converter 10 comprises a shunt resistance $R_{shunt}$ coupled in series between the rectifier circuit 108 and the switching stage 110, and an amplifier circuit 800 (for example, an operational amplifier). The amplifier circuit 800 has a first input coupled upstream of the resistance $R_{shunt}$ and a second input coupled downstream of the resistance $R_{shunt}$ for supplying at output a signal indicative of the current that flows through the resistance $R_{shunt}$. This signal is supplied (for example, through a filtering network comprising a resistance RF and a capacitance CF) to the control circuit 120 for calculation of the input power of the electronic converter 10.

The known solution illustrated in Figure 8, which exploits the control circuit 120 without envisaging the use of a dedicated microprocessor 700, may provide a sufficient accuracy, while maintaining a cost lower than the solution described with reference to Figure 7. On the other hand, the shunt resistance $R_{shunt}$ should have a low resistance value in order not to negatively affect the efficiency of the electronic converter 10, and this renders necessary use of an amplifier circuit 800 for properly detecting the voltage across the electronic converter 10. The amplifier circuit 800 is typically a low-offset amplifier with good temperature stability, and consequently may prove costly.

In the context of the present invention, also the documents EP 2 608 381 A2, US 2015/0028836 A1, US 2013/0342122A1, WO 2011/076707 A2, and EP 3 226 409 A1 are representative of various solutions designed to measure electrical quantities in circuits such as may be converter circuits.

However, the inventor has noted that known solutions for determining the input power of an electronic converter may be costly and/or may entail a reduction in efficiency of the converter itself.

Object and summary

The object of the present disclosure is to provide solutions for determining the input power of an electronic converter (for example, an AC/DC converter as illustrated schematically in Figure 3, or a DC/DC converter) that are easy and inexpensive to produce, do not have an adverse impact on the efficiency of the converter itself, and/or are more reliable than known solutions.

According to various embodiments, the above object is achieved by means of an electronic converter having the features set forth in the claims that follow. The claims also relate to a corresponding lighting system and a corresponding method of operating an electronic converter.

The claims form an integral part of the technical teaching provided herein in relation to the invention.

Various embodiments of the present disclosure relate to an electronic converter. In various embodiments, the electronic converter comprises two input terminals configured to receive an input voltage (for example, an AC voltage) and two output terminals configured to supply a regulated output voltage or a regulated output current. The electronic converter comprises a switching stage coupled to the two input terminals. The switching stage is configured to receive the input voltage and supply the regulated output voltage or the regulated output current.

In various embodiments, the electronic converter comprises an input voltage sensing circuit configured to supply a signal proportional to the input voltage, and an input current sensing circuit configured to supply a signal indicative of an input current of the switching stage.

In various embodiments, the electronic converter comprises a control circuit, which includes an analog-to-digital converter, coupled to the input voltage sensing circuit for detecting one or more sampled values of the signal proportional to the input voltage and coupled to the input current sensing circuit for detecting one or more sampled values of the signal indicative of an input current.

In various embodiments, the input current sensing circuit comprises a first node coupled to a negative input terminal of the electronic converter, a second node connected to a negative input terminal of the switching stage, and a shunt resistance connected between the first node and the second node in a first current path. The input current sensing circuit further comprises an electronic switch connected between the first node and the second node in a second current path in parallel to said shunt resistance, and a voltage divider comprising a first resistance and a second resistance connected in series between the first node and a supply voltage node.

In various embodiments, the analog-to-digital converter in the control circuit is configured to measure a voltage between an intermediate node of the aforesaid voltage divider and the second node of the input current sensing circuit, for receiving the signal indicative of an input current.

In various embodiments, the control circuit is configured to drive the electronic switch, opening the electronic switch in a first time interval and closing the electronic switch in a second time interval, and to determine a value of input power of the electronic converter. The value of input power of the electronic converter is determined as a function of the values of the signal proportional to the input voltage and of the signal indicative of an input current that are sampled during the first time interval, a factor of proportionality between the signal proportional to the input voltage and the input voltage, and values of resistance of the shunt resistance, of the first resistance, and of the second resistance in the input current sensing circuit.

In various embodiments, the electronic converter comprises a rectifier circuit coupled to the two input terminals and configured to supply a rectified input voltage. The switching stage is coupled to the rectifier circuit and is configured to receive the rectified input voltage. The first node of the input current sensing circuit is connected to a negative output terminal of the rectifier circuit.

In various embodiments, a value of resistance of the second current path between the first node and the second node of the input current sensing circuit is lower than a value of resistance of the first current path between the first node and the second node, preferably at least five times lower, more preferably at least ten times lower.

In various embodiments, the input voltage sensing circuit comprises a resistive voltage divider coupled to the two input terminals (for example, via a filter circuit and/or a rectifier circuit) or to the input of the switching stage, and the analog-to-digital converter in the control circuit is connected to an intermediate node of the resistive voltage divider for receiving therefrom the signal proportional to an input voltage.

In various embodiments, the input voltage sensing circuit is coupled to the two input terminals of the electronic converter and comprises a first voltage divider connected between a first conductor (for example, a live conductor) of an electrical supply line that supplies the input voltage and a reference voltage node, and a second voltage divider coupled between a second conductor (for example, a neutral conductor) of the electrical supply line and the reference voltage node. The analog-to-digital converter in the control circuit is connected to respective intermediate nodes of the first voltage divider and of the second voltage divider for receiving from these the signal proportional to an input voltage as a differential signal between the voltages detected at the respective intermediate nodes.

In various embodiments, the analog-to-digital converter in the control circuit is coupled to the intermediate node between the first resistance and the second resistance of the input current sensing circuit via a filter circuit configured to filter the electronic noise in the signal indicative of an input current.

In various embodiments, the input current sensing circuit comprises a Zener diode connected in parallel to the shunt resistance.

In various embodiments, the input current sensing circuit comprises a current-limiting resistance connected in series to the electronic switch. The value of the current-limiting resistance is lower than the value of the shunt resistance, preferably at least five times lower, more preferably at least ten times lower.

In various embodiments, the electronic switch comprises a field-effect transistor, preferably of a MOS type, and the electronic converter comprises a decoupling circuit connected between the control circuit and a control terminal (for example, a gate terminal) of the field-effect transistor. The decoupling circuit is configured to transfer a drive signal from the control circuit to the field-effect transistor.

In various embodiments, the first time interval during which the electronic switch is open has a duration of between 10 ms and 1 s, preferably between 10 ms and 200 ms, more preferably between 100 ms and 200 ms. The second time interval during which the electronic switch is closed has a duration of between 1 s and 5 s, preferably between 2 s and 3 s.

In various embodiments, the control circuit is configured to determine a value of input power of the electronic converter as a function of a plurality of values of the signal proportional to an input voltage and of the signal indicative of an input current that are sampled during the first time interval. The sampling interval of these signals is preferably between 100 $\mu$s and 400 $\mu$s.

In various embodiments, a lighting system comprises a lighting module and an electronic converter according to one or more embodiments.

Brief description of the annexed drawings

Embodiments will now be described, purely by way of non-limiting example, with reference to the annexed drawings, wherein:

- Figure 1 shows a lighting system;
- Figure 2 shows a lighting module;
- Figure 3 shows a block diagram of an electronic converter;
- Figure 4 shows some implementation details of an insulated electronic converter;
- Figures 5 to 8 show various circuits configured to determine the input power of an electronic converter;
- Figure 9 shows a block diagram of one or more embodiments of an electronic converter;
- Figures 10 to 13 show some implementation details of one or more embodiments of an electronic converter;
- Figures 14A, 14B, and 14C show various waveforms in one or more embodiments of an electronic converter; and
- Figure 15 shows a block diagram of one or more embodiments of an electronic converter.

Detailed description of embodiments

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of this description is intended to indicate that a particular configuration, structure, or characteristic described in relation to the embodiment is comprised in at least one embodiment. Hence, phrases such as "in an embodiment" or "in one embodiment" that may be present in various points of the present description do not necessarily refer to one and the same embodiment. In addition, particular conformations, structures, or characteristics may be combined in an adequate way in one or more embodiments.

The references used herein are provided merely for convenience and hence do not define the sphere of protection and the scope of the embodiments.

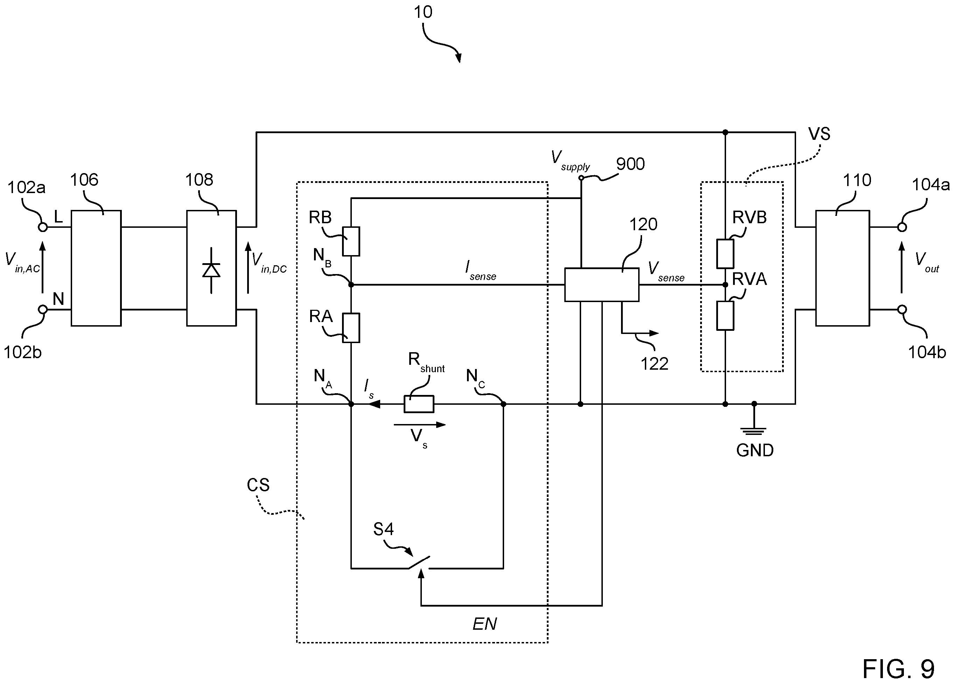

In the Figures 9 to 13 that follow, the parts, elements, or components that have already been described with reference to Figures 1 to 8 are designated by the same references used previously in the above figures; the description of the aforesaid elements described previously will not be repeated hereinafter in order not to overburden the present detailed description.

As mentioned previously, the present disclosure provides solutions for determining the input power of an electronic converter, for example an AC/DC converter as illustrated schematically in Figure 3. For the general description of such an electronic converter, also within a lighting system, reference may hence be made to the description of Figures 1 to 4.

Figure 9 shows an embodiment of an electronic converter 10 comprising a filter circuit 106 (optional), a rectifier circuit 108, and a switching stage 110, which supplies a regulated output voltage/current $V_{out}/i_{out}$. The switching stage 110 comprises a DC/DC conversion circuit and, optionally, a filter circuit and/or a PFC circuit (not visible in Figure 9), according to the known scheme described with reference to Figures 1 to 4.

As illustrated in Figure 9, one or more embodiments may comprise:

- an input voltage sensing circuit VS, configured to detect an input voltage of the electronic converter 10, such as the AC voltage $V_{in,AC}$ supplied at the terminals 102a, 102b by the electrical supply line, or the rectified voltage $V_{in,DC}$ supplied downstream of the rectifier circuit 108;
- an input current sensing circuit CS, configured to detect the current $I_s$ at input to the switching stage 110; and
- a control circuit 120 of the electronic converter 10 (for example, a microprocessor or microcontroller) coupled to the input voltage sensing circuit VS and to the input current sensing circuit CS and configured to receive therefrom signals indicative, respectively, of the value of the input voltage and the value of the input current, and to determine a value of the input power as a function thereof.

For instance, the control circuit 120 of the electronic converter 10 comprises an analog-to-digital converter configured to sample the signals indicative, respectively, of the value of the input voltage and of the input current.

In the embodiment here considered, the input voltage sensing circuit VS may comprise a voltage divider (for example, a resistive voltage divider) coupled between the two output conductors of the rectifier circuit 108. For instance, the voltage divider may comprise an arrangement in series of a first resistance RVA and a second resistance RVB (for example, two resistors) having an intermediate node. This intermediate node may be coupled to the control circuit 120 for supplying thereto a (voltage) signal $V_{sense}$ indicative of (for example, proportional to) the value of the rectified voltage $V_{in,DC}$ at the input of the switching stage 110.

The input voltage sensing circuit VS may be coupled "downstream" of the input current sensing circuit CS, as illustrated in Figure 9, or alternatively may be coupled "upstream" of the input current sensing circuit CS, i.e., directly to the output terminals of the rectifier circuit 108.

In the embodiment here considered, the input voltage sensing circuit VS is configured to reduce the value of the rectified voltage $V_{in,DC}$ supplied by the rectifier circuit 108 to a value suited to being detected by the control circuit 120, which may be implemented with a microcontroller or a microprocessor. For instance, the factor of proportionality between the input voltage and the signal $V_{sense}$ at the output of the sensing circuit VS may be comprised between 50 and 500, and the signal $V_{sense}$ at the output of the sensing circuit VS may have an amplitude comprised between 0 V and 5 V.

The control circuit 120 is configured to control the switching stage 110 (in particular, to control switching thereof in order to supply at output the desired regulated voltage/current value) and optionally for communicating with devices external to the electronic converter 10, for example via an interface and an external communication line 122, such as a DALI line.

The control circuit 120 is moreover configured to determine a value of the input power of the electronic converter

10 as a function of the signals indicative of the value of the input voltage $V_{sense}$ and of the input current $I_{sense}$, supplied respectively by the circuits VS and CS. The value of power determined by the control circuit 120 can be communicated to one or more external devices, for example via the communication line 122.

In one or more embodiments, the control circuit 120 may be implemented with a microcontroller that presents a modest level of performance in order to reduce its cost. In this case, and in any case in general, it is preferable for the signals generated by the voltage sensing circuit VS and by the current sensing circuit CS that are supplied at the input of the control circuit 120, to have an appropriate amplitude in order to use, when possible, the entire input range (scale) of the analog-to-digital converter inside the control circuit 120. This solution makes it possible to improve the accuracy of measurement of the quantities, voltage and current, and consequently facilitates a more accurate measurement of the input power of the electronic converter 10.

In one or more embodiments as exemplified in Figure 9, the input current sensing circuit CS comprises:

- a shunt resistance $R_{shunt}$ (for example, a resistor) connected (for example, directly) in series between the rectifier circuit 108 and the switching stage 110 (for example, coupled to the "negative" conductor at the output of the rectifier circuit 108, as illustrated in Figure 9), where the shunt resistance $R_{shunt}$ preferably has a node coupled to a reference voltage node GND (e.g., a ground node), preferably the node coupled to the input of the switching stage 110;
- a voltage divider comprising a first resistance RA and a second resistance RB (for example, two resistors) connected in series between a supply voltage node 900 and the node $N_A$ of the shunt resistance $R_{shunt}$ that is not coupled to the reference voltage node GND, where the supply voltage node 900 is configured to supply a supply voltage $V_{supply}$ (for example, the same supply voltage as that of the control circuit 120), and where the node $N_B$ intermediate between the resistances RA and RB is coupled to the control circuit 120 for supplying thereto a (voltage) signal $I_{sense}$ indicative of the value of the input current; and
- an electronic switch S4, connected in parallel to the shunt resistance $R_{shunt}$ and driven by the control circuit 120 by means of a control signal (for example, a digital signal) *EN*.

Consequently, in one or more embodiments as exemplified in Figure 9, as a result of the switching stage 110 supplying power to a load (coupled to the terminals 104a, 104b), a certain current $I_s$ flows through the shunt resistance $R_{shunt}$. This current determines a voltage drop $V_s$ on the shunt resistance $R_{shunt}$. The voltage signal $V_s$ is transferred (with a certain offset) at the input of the control circuit 120 via the voltage divider RA, RB that generates the (voltage) signal $I_{sense}$.

In particular, the voltage $V_B$ at node $N_B$ (corresponding to the signal $I_{sense}$) can be determined - possibly with minor approximations - via the following equation:

$$V_B = \frac{V_{supply} \cdot RA}{RA + RB} - \frac{R_{shunt} \cdot RB \cdot I_S}{RA + RB} \qquad (1)$$

where

$$R_{shunt} \cdot I_S = V_S \qquad (2)$$

The voltage $V_B$ at the node $N_B$ can hence be converted into a digital value *ADvalue* via an *N*-bit analog-to-digital converter (for example, with *N* = 12 bits) comprised in the control circuit 120, according to the following equation:

$$ADvalue = \frac{2^N}{VADref} \cdot V_B \qquad (3)$$

where *VADref* is the value of an internal voltage reference of the analog-to-digital converter.

The control circuit 120 can thus be configured to determine the value of the current $I_S$ at the input of the electronic converter as a function of the digital value *ADvalue*. For instance, the value of the current $I_S$ can be determined via the following equation:

$$I_{sampled} = \frac{V_{supply} \cdot RA}{R_{shunt} \cdot RB} - \frac{VADref \cdot ADvalue}{2^N} \cdot \frac{RA + RB}{R_{shunt} \cdot RB} \qquad (4)$$

Purely by way of non-limiting example, one or more embodiments may comprise components sized as follows:

$R_{shunt}$ = 5.6 Ω
RB = 1500 Ω
RA = 1000 Ω
$V_{supply}$ = 3. 3 V
$VADref$ = $V_{supply}$/2 = 1.65 V

In various embodiments, the control circuit 120 is configured to detect the values of the signals $V_{sense}$ and $I_{sense}$ at regular intervals (for example, periodic, with a period of between 100 μs and 400 μs) and, for each pair of values detected, calculate a value of input power.

In various embodiments, the input power of the electronic converter 10 may be calculated by averaging in time the calculated values. For instance, the control circuit 120 may be configured to average the values of power calculated over the range of a semi-period of the input voltage $V_{in,AC}$ (which, in the case of a voltage $V_{in,AC}$ having a frequency of 50 Hz, corresponds to a time interval of 10 ms), or over a certain number of semi-periods of the input voltage $V_{in,AC}$ (for example, 5, 10, or 20 consecutive semi-periods, corresponding to 50, 100 or 200 ms, respectively, in the case of a voltage $V_{in,AC}$ having a frequency of 50 Hz).

The inventor has noted that the shunt resistance $R_{shunt}$ coupled in series between the rectifier circuit 108 and the switching stage 110 can determine power losses that have a negative impact on the efficiency of the electronic converter 10.

In the purely exemplary case illustrated previously (with $R_{shunt}$ = 5.6 Ω), considering a voltage drop $V_s$ = 2 V having an effective value of 1.41 V RMS (root mean square), the power dissipated on the shunt resistance is found to be equal to approximately 0.357 mW. Since a circuit converter sized as illustrated previously can be used, for example, for supplying an output power of approximately 40 W, such a power dissipation on the shunt resistance can bring about a loss of efficiency of almost one percentage point.

The inventor has noted that, since the power at input to the electronic converter 10 typically varies in a rather slow way, the time interval that elapses between one measurement of this power and the next can be chosen even rather long, for example approximately 2 or 3 s.

In order not to dissipate power on the shunt resistance $R_{shunt}$ during the time intervals between one measurement of the input power and the next, various embodiments of the electronic converter 10 comprise an electronic switch S4 coupled in parallel to the shunt resistance $R_{shunt}$, as illustrated in Figure 9, and controlled by the control circuit 120 via a control signal *EN*.

In one or more embodiments, the electronic switch S4 may comprise a transistor, for example a MOSFET.

Consequently, in one or more embodiments, the control circuit 120 may be configured to:

- drive opening of the electronic switch S4 at a given instant $t_0$, allowing the current $I_s$ to flow through the shunt resistance $R_{shunt}$ in order to detect the amplitude of the current $I_s$ via the signal $I_{sense}$;
- sample (for example, periodically, with a period of between 100 μs and 400 μs) respective values of the signals $I_{sense}$ and $V_{sense}$ during a certain time interval of duration Δt1, with this time interval preferably corresponding to one or more semi-periods of the input voltage $V_{in,AC}$ (for example, from one to twenty semi-periods, corresponding to a time interval of 10 to 200 ms in the case of a frequency of 50 Hz);
- at a given instant $t_1$ = $t_0$ + Δt1, drive closing of the electronic switch S4;
- calculate, as a function of the values of the signals $I_{sense}$ and $V_{sense}$ sampled during the time interval Δ t1, a value of input power of the electronic converter, and optionally communicate this value at output from the electronic converter 10 (for example, through a data communication line 122 such as a DALI line); and
- repeat the previous steps, preferably at regular time intervals (for example, periodically, with a period indicatively comprised between 1 and 5 s, preferably between 2 and 3 s).

In various embodiments, the power dissipated on the shunt resistance $R_{shunt}$ can hence advantageously be reduced (even by a factor of 10 or higher), the greater the distance in time between two successive measurements of the input power of the converter, in so far as no power is dissipated on the shunt resistance $R_{shunt}$ while the signals $I_{sense}$ and $V_{sense}$ are not being sampled.

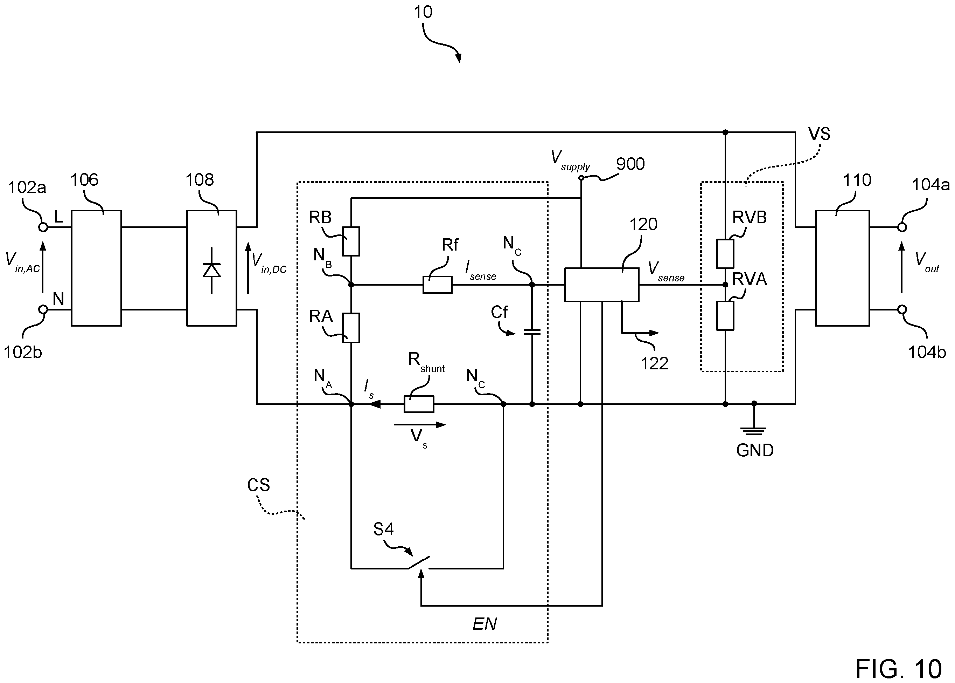

In addition, as exemplified in Figure 10, one or more embodiments may comprise a filter circuit of an RC type between the node $N_B$ and the respective input of the control circuit 120, configured to reduce the electronic noise on the signal $I_{sense}$.

In particular, as illustrated in Figure 10, the electronic converter may comprise a resistance Rf connected between the node $N_B$ and the input of the control circuit 120 (i.e., the node designated by $N_C$) and a capacitance Cf connected between the input of the control circuit 120 and the reference voltage node GND.

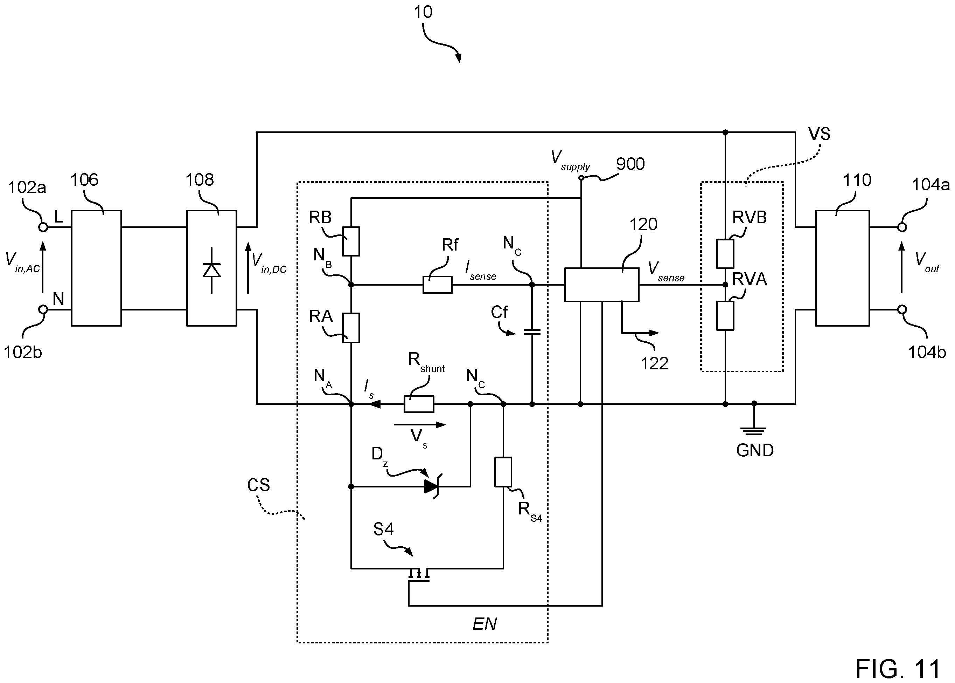

In addition, as exemplified in Figure 11 (where the electronic switch S4 is represented with an n-type MOSFET, according to a preferred embodiment), one or more embodiments may comprise:

- a Zener diode $D_Z$ coupled in parallel to the shunt resistance $R_{shunt}$, in particular having the anode connected to the node $N_A$ and the cathode connected to the reference node GND; and/or
- a resistance $R_{S4}$ (for example, a resistor) connected in series to the electronic switch S4, preferably between the electronic switch S4 and the reference node GND.

The Zener diode $D_Z$ has the function of limiting the voltage applied to the shunt resistance $R_{shunt}$ in the case of overcurrents, for example due to surge or inrush phenomena.

The resistance $R_{S4}$ has the function of limiting the current that flows through the electronic switch S4 (in particular when this is implemented with a transistor, for example a MOSFET) when overcurrents occur. The value of the resistance $R_{S4}$ may be sized so as to be relatively lower than the value of the shunt resistance $R_{shunt}$, for example approximately ten times lower (for example, $R_{S4} = 0.56\ \Omega$ if $R_{shunt} = 5.6\ \Omega$).

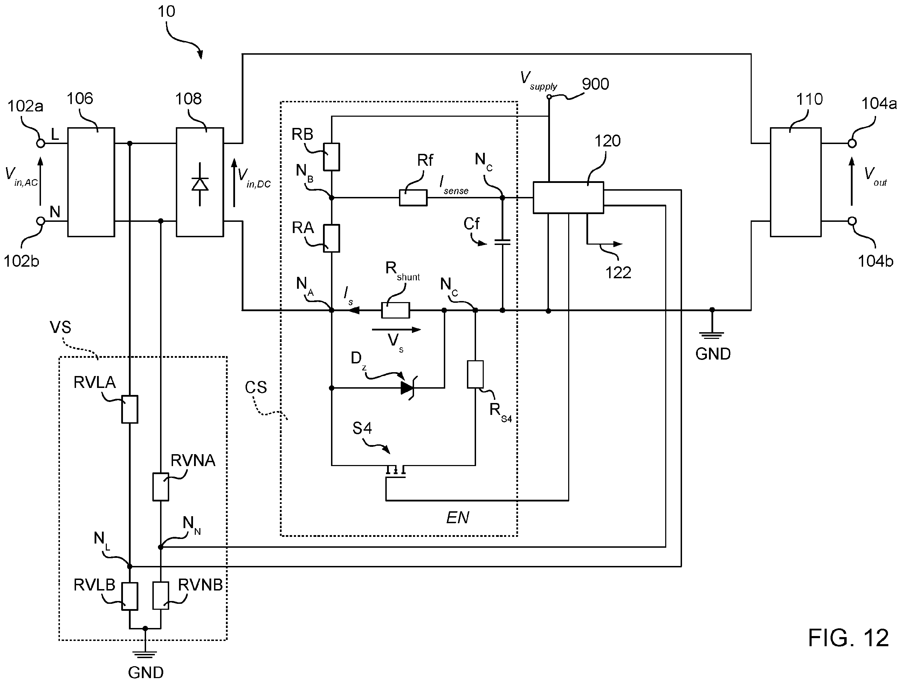

Alternatively, various embodiments may comprise an input voltage sensing circuit VS different from the one illustrated in Figures 9, 10, and 11. As illustrated in Figure 12, the input voltage may be detected "upstream" of the rectifier circuit 108, for example using a sensing circuit VS that includes:

- a first voltage divider, comprising a first resistance RVLA and a second resistance RVLB (for example, two resistors) connected in series between the live conductor L of the electrical supply line and a reference voltage node GND; and
- a second voltage divider, comprising a first resistance RVNA and a second resistance RVNB (for example, two resistors) connected in series between the neutral conductor N of the electrical supply line and a reference voltage node GND.

In the embodiment here considered, the control circuit 120 of the electronic converter 10 may be coupled to a first node $N_L$ intermediate with respect to the first voltage divider and a second node $N_N$ intermediate with respect to the second voltage divider (for example, by means of respective inputs of the analog-to-digital converter inside the control circuit 120). The control circuit 120 may be configured to determine a value of the input voltage as a function of the voltage values detected at the intermediate nodes $N_L$ and $N_N$ (for example, as a function of the difference between the two voltages detected).

The above embodiment enables measurement of the input voltage in a differential way upstream of the rectifier circuit 108, thus taking into account the voltage drop on the rectifier circuit itself. Consequently, the input power calculated is more accurate, since it comprises the power dissipated in the rectifier circuit 108.

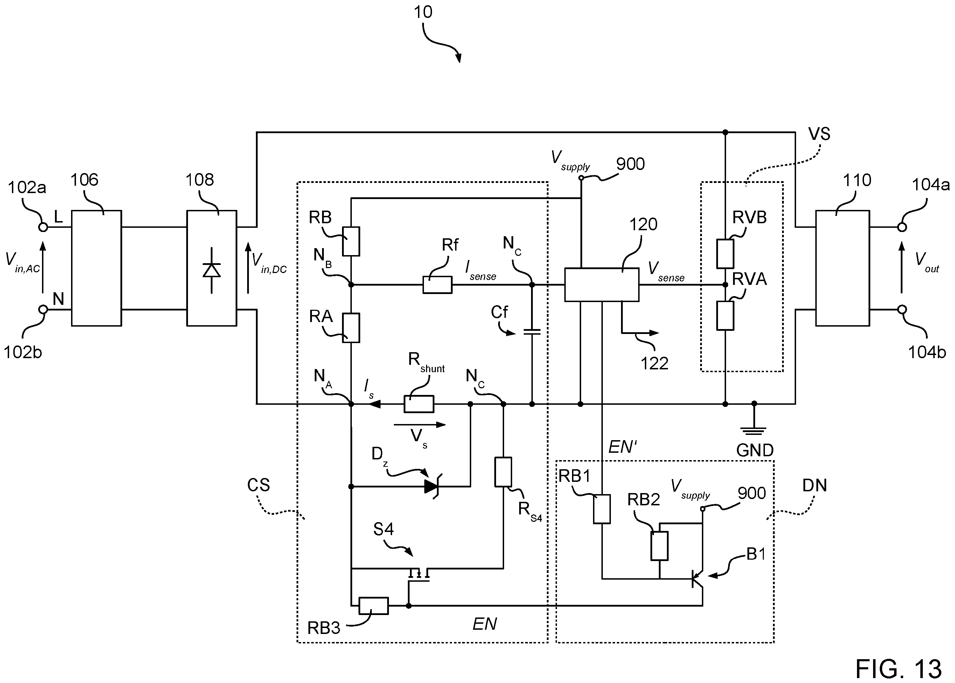

In addition or as an alternative, in various embodiments, as exemplified in Figure 13, the electronic switch S4 may be driven via a decoupling circuit DN coupled between the control circuit 120 and a control terminal of the switch S4 (for example, a gate terminal in the case where the switch S4 is implemented with a field-effect transistor of a MOS type).

In particular, in the embodiment here considered, the decoupling circuit DN comprises a transistor (for example, a bipolar transistor) B1 having a current path coupled between the node 900 of the supply voltage $V_{supply}$ and the control terminal of the electronic switch S4. The control terminal of the transistor B1 (for example, a base terminal) is coupled to the control circuit 120, for example via a resistance RB1. The transistor B1 receives from the control circuit 120 a signal *EN'* for activating or deactivating the electronic switch S4 (i.e., rendering it conductive or non-conductive, closed or open).

In addition, a resistance RB2 may be coupled between the control terminal of the transistor B1 and the node 900 of the supply voltage $V_{supply}$.

In addition, a resistance RB3 may be coupled between the control terminal of the switch S4 and the node $N_A$ (for example, between the gate terminal and the source terminal of a MOSFET that implements the switch S4).

In the embodiment here considered, the logic level of the signal *EN'* supplied by the control circuit 120 is reversed with respect to the logic level of the signal *EN* received at the switch S4.

It will be noted that one or more of the resistances $R_{shunt}$, Rs, R, RH, RL, RF, Rf, $R_{S4}$, RA, RB, RVA, RVB, RVLA, RVLB, RVNA, RVNB, RB1, RB2 and RB3 may be implemented by means of discrete components, such as resistors and/or by means of other resistive components, including non-discrete ones (for example, resistances integrated on silicon).

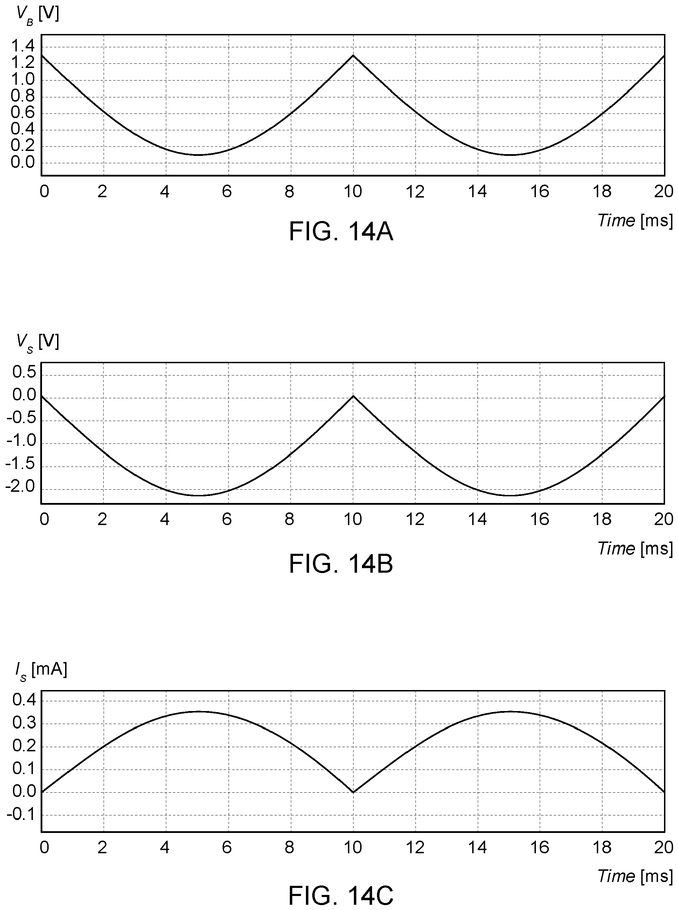

Figures 14A, 14B and 14C exemplify the possible time plots of electrical signals in various embodiments. In particular:

- Figure 14A illustrates the plot of the voltage $V_B$ at the node $N_B$,
- Figure 14B illustrates the plot of the voltage $V_S$ on the shunt resistance $R_{shunt}$; and
- Figure 14C illustrates the plot of the current $I_s$ through the shunt resistance $R_{shunt}$.

Various embodiments, as described herein, facilitate a measurement of the input power of the electronic converter with an improved accuracy as compared to known solutions. In particular, the accuracy may be better than $\pm 1\%$ in an input power range of from $P_{in}/2$ to $P_{in}$, where $P_{in}$ is the maximum input power of the electronic converter.

Various embodiments as described herein facilitate a measurement of the input power by means of a reliable and low-cost circuit, where the circuit does not comprise any operational amplifier and makes it possible to achieve a satisfactory accuracy, albeit using a low-cost microcontroller to implement the control circuit 120.

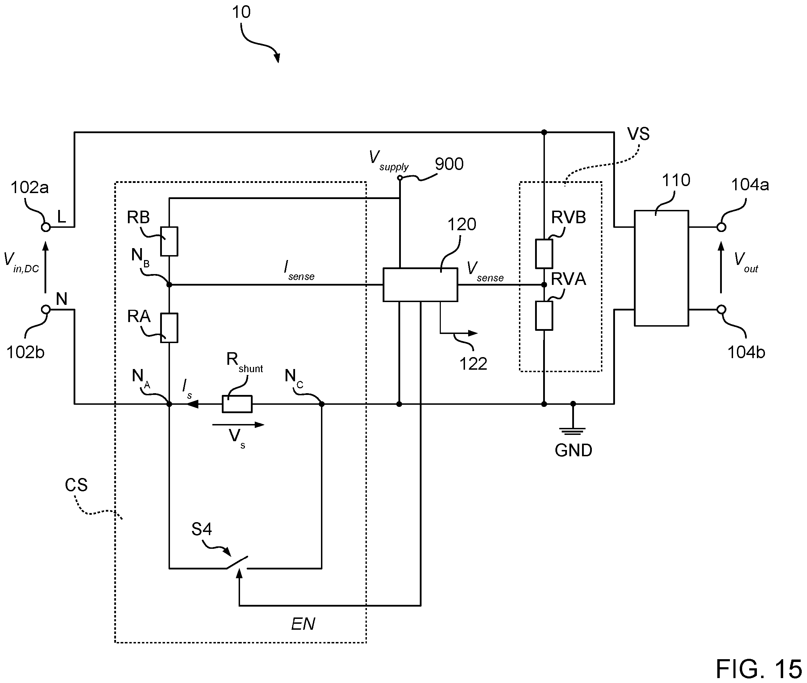

Various embodiments have been described with reference to Figures 9 to 13, which illustrate purely by way of example a converter of an AC/DC type. Obviously, the teachings provided herein for calculation of the input power of an electronic converter may equally be applied to converters of a DC/DC type. In this case, the DC/DC converter may not be provided with a filter circuit 106 and/or a rectifier circuit 108, and may be configured to receive directly at the input terminals 102a, 102b a DC voltage $V_{in,DC}$ as input voltage of the converter, as exemplified in Figure 15.

Again, it will be noted that any one of the embodiments described with reference to Figures 9 to 13 (i.e., embodiments comprising a filter circuit 106 and/or a rectifier circuit 108) may likewise be used for a conversion of a DC/DC type, receiving a DC voltage at the input terminals 102a, 102b. In addition or as an alternative, in any one of the embodiments described with reference to Figures 9 to 13 the output nodes of the rectifier circuit 108 may be rendered accessible at the outside of the circuit via respective terminals, for receiving a DC input voltage.

Of course, without prejudice to the principle of the invention, the details of construction and the embodiments may vary, even significantly, with respect to what has been illustrated herein purely by way of non-limiting example, without thereby departing from the scope of the invention, as defined by the annexed claims.

### LIST OF REFERENCE SIGNS

| | |
|---|---|
| Electronic converter | 10 |
| Input terminal | 102a, 102b |
| Output terminal | 104a, 104b |
| Filter circuit | 106, 112 |
| Rectifier circuit | 108, 116 |
| Switching stage | 110 |
| DC/DC conversion circuit | 114 |
| Control circuit | 120 |
| Communication line | 122 |
| Lighting module | 20 |
| Input terminal | 200a, 200b |
| LED or laser diode | L' |
| LED string | 22 |
| Current regulator | 24 |
| Microprocessor | 700 |
| Operational amplifier | 800 |
| Supply voltage node | 900 |
| Transformer | T |
| Primary winding | T1 |
| Secondary winding | T2, $L_0$ |
| Electronic switch | $S_1$, $S_2$, $S_3$, $S_4$ |
| Inductor | L1 |
| Diode | D1 |
| Voltage sensing circuit | VS |
| Current sensing circuit | CS |
| Shunt resistance | $R_{shunt}$ |
| Resistance | Rs, R, RH, RL, RF, Rf, $R_{S4}$ |
| Resistance | RA, RB, RVA, RVB |
| Resistance | RVLA, RVLB, RVNA, RVNB |
| Resistance | RB1, RB2, RB3 |
| Capacitance | C, CF, Cf |
| Zener diode | $D_z$ |
| Decoupling circuit | DN |

(continued)

| | |
|---|---|
| Transistor | B1 |
| Node | $N_A$, $N_B$, $N_C$, $N_L$, $N_N$ |
| Live conductor | L |
| Neutral conductor | N |
| AC input voltage | $V_{in,AC}$ |
| Regulated output voltage | $V_{out}$ |
| Regulated output current | $i_{out}$ |
| Rectified voltage | $V_{in,DC}$ |
| Bus voltage | $V_{bus}$ |
| Input current | $I_s$ |
| Supply voltage | $V_{supply}$ |
| Signal indicative of the input voltage | $V_{sense}$ |
| Signal indicative of the input current | $I_{sense}$ |
| Control signal | EN, EN' |
| Voltage on the shunt resistance | $V_S$ |

**Claims**

1. An electronic converter (10), comprising:

- two input terminals (102a, 102b) configured to receive an input voltage ($V_{in,AC}$; $V_{in,DC}$);
- two output terminals (104a, 104b) configured to supply a regulated output voltage ($V_{out}$) or a regulated output current ($i_{out}$);
- a switching stage (110; 112, 114) coupled to the two input terminals (102a, 102b), the switching stage (110; 112, 114) being configured to receive said input voltage ($V_{in,AC}$; $V_{in,DC}$) and supply said regulated output voltage ($V_{out}$) or regulated output current ($i_{out}$);
- an input voltage sensing circuit (VS) configured to supply a signal ($V_{sense}$) proportional to said input voltage ($V_{in,AC}$; $V_{in,DC}$);
- an input current sensing circuit (CS) configured to supply a signal ($I_{sense}$) indicative of an input current ($I_s$) of said switching stage (110; 112, 114); and
- a control circuit (120) comprising an analog-to-digital converter coupled to the input voltage sensing circuit (VS) to sense one or more sampled values of said signal ($V_{sense}$) proportional to said input voltage ($V_{in,AC}$; $V_{in,DC}$), and coupled to the input current sensing circuit (CS) to sense one or more sampled values of said signal ($I_{sense}$) indicative of an input current ($I_s$),

wherein the input current sensing circuit (CS) comprises:

- a first node ($N_A$) coupled (106, 108) to a negative input terminal (102b) of said electronic converter (10);
- a second node ($N_C$) connected to a negative input terminal of said switching stage (110; 112, 114);
- a shunt resistance ($R_{shunt}$) connected between said first node ($N_A$) and said second node ($N_C$) in a first current path;
- an electronic switch (S4) connected between said first node ($N_A$) and said second node ($N_C$) in a second current path in parallel to said shunt resistance ($R_{shunt}$) ; and
- a voltage divider comprising a first resistance (RA) and a second resistance (RB) connected in series between said first node ($N_A$) and a supply voltage ($V_{supply}$) node (900),

wherein the analog-to-digital converter in the control circuit (120) is configured to measure a voltage between a node ($N_B$) intermediate said first resistance (RA) and said second resistance (RB) and the second node ($N_C$) of the input current sensing circuit (CS) to receive said signal ($I_{sense}$) indicative of an input current ($I_s$);

wherein the control circuit (120) is configured to:

- drive (EN) said electronic switch (S4), opening the electronic switch (S4) in a first time interval and closing the electronic switch (S4) in a second time interval; and
- determine a value of input power of the electronic converter (10) as a function of:

- said values of said signal ($V_{sense}$) proportional to said input voltage ($V_{in,AC}$; $V_{in,DC}$) and of said signal ($I_{sense}$) indicative of an input current ($I_s$) that are sampled during said first time interval;
- a factor of proportionality between said signal ($V_{sense}$) proportional to said input voltage and said input voltage ($V_{in,DC}$; $V_{in,AC}$) ; and
- values of resistance of the shunt resistance ($R_{shunt}$), of the first resistance (RA), and of the second resistance (RB) in the input current sensing circuit (CS).

2. The electronic converter (10) of claim 1, comprising a rectifier circuit (108) coupled (106) to the two input terminals (102a, 102b) and configured to supply a rectified input voltage ($V_{in,DC}$), wherein:

- said switching stage (110; 112, 114) is coupled to the rectifier circuit (108) and is configured to receive said rectified input voltage ($V_{in,DC}$); and
- said first node ($N_A$) of the input current sensing circuit (CS) is connected to a negative output terminal of said rectifier circuit (108).

3. The electronic converter (10) of claim 1 or claim 2, wherein a resistance value of said second current path between said first node ($N_A$) and said second node ($N_C$) is lower than a resistance value of said first current path between said first node ($N_A$) and said second node ($N_C$), preferably at least five times lower, more preferably at least ten times lower.

4. The electronic converter (10) of any of claims 1 to 3, wherein:

- the input voltage sensing circuit (VS) comprises a resistive voltage divider (RVA, RVB) coupled to said two input terminals (102a, 102b) or to the input of the switching stage (110; 112, 114); and
- the analog-to-digital converter in the control circuit (120) is connected to an intermediate node of said resistive voltage divider (RVA, RVB) to receive therefrom said signal ($V_{sense}$) proportional to said input voltage ($V_{in,DC}$).

5. The electronic converter (10) of any of claims 1 to 3, wherein the input voltage sensing circuit (VS) is coupled to said two input terminals (102a, 102b) of the electronic converter (10) and comprises:

- a first voltage divider (RVLA, RVLB) connected between a first conductor (L) of an electrical supply line that supplies said input voltage ($V_{in,AC}$) and a reference voltage node (GND); and
- a second voltage divider (RVNA, RVNB) connected between a second conductor (N) of said electrical supply line that supplies said input voltage ($V_{in,AC}$) and said reference voltage node (GND),

wherein the analog-to-digital converter in the control circuit (120) is connected to respective intermediate nodes ($N_L$, $N_N$) of the first voltage divider (RVLA, RVLB) and of the second voltage divider (RVNA, RVNB) to receive therefrom said signal proportional to an input voltage as differential signal between the voltages detected at said respective intermediate nodes ($N_L$, $N_N$).

6. The electronic converter (10) of any of the previous claims, wherein the analog-to-digital converter in the control circuit (120) is coupled to the node intermediate ($N_B$) said first resistance (RA) and said second resistance (RB) via a filter circuit (Rf, Cf) configured to filter the electronic noise in said signal ($I_{sense}$) indicative of an input current ($I_s$).

7. The electronic converter (10) of any of the previous claims, wherein the input current sensing circuit (CS) comprises a Zener diode ($D_z$) connected in parallel to the shunt resistance ($R_{shunt}$).

8. The electronic converter (10) of any of the previous claims, wherein the input current sensing circuit (CS) comprises a current limiting resistance ($R_{S4}$) connected in series to said electronic switch (S4), the value of said current limiting resistance ($R_{S4}$) being lower than the value of the shunt resistance ($R_{shunt}$), preferably at least five times lower, more preferably at least ten times lower.

9. The electronic converter (10) of any of the previous claims, wherein said electronic switch (S4) comprises a field-effect transistor, preferably a MOS field-effect transistor, and wherein the electronic converter comprises a decoupling circuit (DN) connected between the control circuit (120) and a control terminal of the field-effect transistor, the decoupling circuit (DN) being configured to transfer a drive signal (*EN, EN'*) from the control circuit (120) to the field-effect transistor.

10. The electronic converter (10) of any of the previous claims, wherein:

    - said first time interval during which the electronic switch (S4) is open has a duration of between 10 ms and 1 s, preferably between 10 ms and 200 ms, more preferably between 100 ms and 200 ms; and
    - said second time interval during which the electronic switch (S4) is closed has a duration of between 1 s and 5 s, preferably between 2 s and 3 s.

11. The electronic converter (10) of any of the previous claims, wherein the control circuit (120) is configured to determine a value of input power of the electronic converter (10) as a function of a plurality of values of said signal ($V_{sense}$) proportional to an input voltage and of said signal ($I_{sense}$) indicative of an input current ($I_s$) that are sampled during said first time interval, wherein the sampling interval of said signals is preferably between 100 $\mu$s and 400 $\mu$s.

12. A lighting system comprising a lighting module (20) and an electronic converter (10) according to any of the previous claims.

13. A method of operating an electronic converter (10) according to any of claims 1 to 11, comprising:

    - receiving an input voltage ($V_{in,AC}$; $V_{in,DC}$) at said two input terminals (102a, 102b);
    - sensing (VS) one or more sampled values of a signal ($V_{sense}$) proportional to said input voltage ($V_{in,AC}$; $V_{in,DC}$);
    - sensing (CS) one or more sampled values of a signal ($I_{sense}$) indicative of an input current ($I_s$) of said switching stage (110; 112, 114);
    - driving (*EN*) said electronic switch (S4) in such a way as to open the electronic switch (S4) in a first time interval and close the electronic switch (S4) in a second time interval;
    - determining a value of input power of the electronic converter (10) as a function of:

        - values of said signal ($V_{sense}$) proportional to an input voltage and of said signal ($I_{sense}$) indicative of an input current ($I_s$) that are sampled during said first time interval;
        - a factor of proportionality between said signal ($V_{sense}$) proportional to an input voltage and said input voltage ($V_{in,DC}$; $V_{in,AC}$) ; and
        - values of resistance of the shunt resistance ($R_{shunt}$), of the first resistance (RA), and of the second resistance (RB) in the input current sensing circuit (CS).

FIG. 1

FIG. 2

FIG. 3

FIG. 4

FIG. 5

FIG. 6

FIG. 7

FIG. 8

FIG. 9

EP 3 829 043 A1

FIG. 10

EP 3 829 043 A1

FIG. 11

FIG. 12

EP 3 829 043 A1

FIG. 13

EP 3 829 043 A1

$V_B$ [V]

FIG. 14A

Time [ms]

$V_S$ [V]

FIG. 14B

Time [ms]

$I_S$ [mA]

FIG. 14C

Time [ms]

FIG. 15

EP 3 829 043 A1

Europäisches
Patentamt

European
Patent Office

Office européen
des brevets

# EUROPEAN SEARCH REPORT

Application Number

EP 20 20 6854

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 03/001315 A1 (CHAMPION MICROELECTRONIC CORP [US]; HWANG JEFFREY [US]) 3 January 2003 (2003-01-03) * figure 1 * * page 3, lines 10-12 * ----- | 1-13 | INV. H02M1/42 H05B45/3725 H02M3/335 G01R21/06 |
| Y | US 2015/009715 A1 (PARK JOUNG HU [KR]) 8 January 2015 (2015-01-08) * paragraphs [0025], [0029]; figure 1 * ----- | 1-13 | |
| Y,D | EP 3 226 409 A1 (MITSUBISHI HEAVY IND LTD [JP]) 4 October 2017 (2017-10-04) * paragraphs [0040], [0056]; figures 1-3 * ----- | 1-13 | |
| A | US 2006/061337 A1 (KIM JUNG-WON [KR] ET AL) 23 March 2006 (2006-03-23) * figure 1 * ----- | 1-13 | |
| | | | TECHNICAL FIELDS SEARCHED (IPC) |
| | | | H02M H05B G01R |

The present search report has been drawn up for all claims

| Place of search | Date of completion of the search | Examiner |
|---|---|---|
| The Hague | 7 April 2021 | van Wesenbeeck, R |

EPO FORM 1503 03.82 (P04C01)

## ANNEX TO THE EUROPEAN SEARCH REPORT
## ON EUROPEAN PATENT APPLICATION NO.

EP 20 20 6854

This annex lists the patent family members relating to the patent documents cited in the above-mentioned European search report.
The members are as contained in the European Patent Office EDP file on
The European Patent Office is in no way liable for these particulars which are merely given for the purpose of information.

07-04-2021

| Patent document cited in search report | | | Publication date | Patent family member(s) | | | Publication date |
|---|---|---|---|---|---|---|---|
| WO 03001315 | A1 | | 03-01-2003 | AU | 2002322418 | A1 | 08-01-2003 |
| | | | | US | 2002196006 | A1 | 26-12-2002 |
| | | | | US | 2002196644 | A1 | 26-12-2002 |
| | | | | US | 2003020442 | A1 | 30-01-2003 |
| | | | | WO | 03000025 | A2 | 03-01-2003 |
| | | | | WO | 03001315 | A1 | 03-01-2003 |
| US 2015009715 | A1 | | 08-01-2015 | KR | 101255965 | B1 | 23-04-2013 |
| | | | | US | 2015009715 | A1 | 08-01-2015 |
| | | | | WO | 2013111954 | A1 | 01-08-2013 |
| EP 3226409 | A1 | | 04-10-2017 | EP | 3226409 | A1 | 04-10-2017 |
| | | | | ES | 2715039 | T3 | 31-05-2019 |
| | | | | JP | 6525330 | B2 | 05-06-2019 |
| | | | | JP | 2017184325 | A | 05-10-2017 |
| US 2006061337 | A1 | | 23-03-2006 | CN | 1753290 | A | 29-03-2006 |
| | | | | DE | 102005044348 | A1 | 06-04-2006 |
| | | | | JP | 4580849 | B2 | 17-11-2010 |
| | | | | JP | 4693868 | B2 | 01-06-2011 |
| | | | | JP | 2006094697 | A | 06-04-2006 |
| | | | | JP | 2008199896 | A | 28-08-2008 |
| | | | | KR | 20060026701 | A | 24-03-2006 |
| | | | | TW | I307570 | B | 11-03-2009 |
| | | | | US | 2006061337 | A1 | 23-03-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2608381 A2
- US 20150028836 A1
- US 20130342122 A1
- WO 2011076707 A2
- EP 3226409 A1